# EUROPEAN PATENT APPLICATION

(11) **EP 4 703 959 A1**
(43) Date of publication of application: **04.03.2026**
(21) Application number: 24465558.5
(22) Date of filing: 27.08.2024
(51) Int. Cl.: G06F 30/3308

(54) **METHOD OF OPERATING A HARDWARE VERIFICATION DEVICE, HARDWARE VERIFICATION DEVICE, COMPUTER PROGRAM PRODUCT AND COMPUTER-READABLE STORAGE MEDIUM**

(71) Applicant: Siemens Aktiengesellschaft, 80333 München (DE)
(72) Inventor: OPRICA, Daniel, 500170 Brasov, Brasov (RO); BANCIU, Nicolae-Alexandru, 500096 Brasov, Brasov (RO); GHEORGHE, Stefan, 100456 Ploiesti, Prahova (RO); FALCESCU, Catalin-Ionut, 500170 Brasov, Brasov (RO); SAVU, Alexandru, 115100 Campulung, Arges (RO)
(74) Representative: Fierascu, Cosmina-Catrinel

(57) **Abstract**

The invention relates to a method of operating a hardware verification device (10) comprising the following steps: Receiving a verification plan (22) defining the metrics to be covered by verification simulations of the design under test (12) using the hardware description representation (18), wherein the verification plan (22) defines at least one coverage metric for describing a verification coverage related to the verification; performing verification simulations of the design under test (12) according to the verification plan (22); generating based on the respective global coverage level values (32) for the respective hardware modules (20) respective global coverage level values (32) for the respective schema modules (16) according to a predefined conversion table (36);providing the respective global coverage level values (32) for the respective schema modules (16) to the schema representation (14) of the design under test (12); Providing a signal (40) comprising the schema representation (14) of the design under test (12).

## Description

The present invention relates to a method of operating a hardware verification device, a hardware verification device, a computer program product and a computer-readable storage medium.

For evaluating a design under test verification procedures are performed on the design under test. Verification procedures are performed according to predefined verification plans. The verification plan defines an amount of code or functions to be verified during the verification procedure. To monitor a progress of the verification procedure, coverage reports are provided after the simulations giving coverage level values describing the coverage of the amount of code of functions tested during the respective simulation.

Functional coverage and code coverage reports are crucial tools for verification engineers in evaluating a Design Under Test (DUT) and identifying areas where coverage results have not reached 100%. Current tools offer mechanisms to analyze verification metrics results, providing links between coverage percentages and the associated code constructs. This aids in assessing verification completeness and ensuring that all aspects of the DUT have been thoroughly tested.

However, the coverage level values are related to specific modules of a hardware representation of the design under test optimized for the simulation procedure. For further analysis or evaluation other representations of the design under test may be preferable.

In addition, these tools provide a schematic view of the current DUT implementation at various levels of abstraction, allowing engineers to better understand the structure and behavior of the design. However, existing solutions lack the capability to create structural visualizations that can easily identify "white spots", or areas where testing has been insufficient, and correlate these with the DUT structure.

The process of analyzing verification metrics alone may not always provide a clear picture of verification progress. An overlay of the metrics onto the DUT structure is often necessary to fully understand the state of verification and identify any areas that require further testing. By combining structural visualizations with coverage data, engineers can quickly and easily identify areas of the DUT that have not been adequately covered and take action to improve verification completeness.

In summary, a solution that offers both functional and code coverage analysis along with structural visualization capabilities would greatly enhance the ability of verification engineers to effectively analyze and understand the state of their Design Under Test. By providing a clear view of DUT structure, correlating this with coverage percentages, and identifying "white spots" in the design, such a solution would streamline the verification process and improve overall efficiency.

Verification engineers are using functional coverage and code coverage reports to analyze a Design Under Test (DUT) and access those lines of code where coverage results didn't reach 100%. Current tools are providing mechanisms to analyze verification metrics results for verification completeness and links to corelate coverage percentages with the associate code constructs.

At the same time these tools are able to provide a schematic view of the current DUT implementation, at different levels of abstraction. However, there are no mechanisms to create structural visualizations and identify easily the "white spots" and the correlations between DUT structure and coverage percentages. Sometimes, just analyzing the verification metrics is not that easy to determine the verification progress without an overlaying over the DUT structure.

Among different methodologies used today for digital design functional verification, the Coverage Driven Verification (CDV) consists of using functional coverage metrics to analyze the verification completeness. The coverage metrics are defined early in the functional verification process and implemented later in the verification environment using specific statements provided by a Hardware Verification Languages (HVLs). By analyzing the Functional Specification (describing the functionalities the digital design must have) a Verification Plan is usually created. The functional coverage metrics are then defined, based on the verification needs, to fulfill the Verification Plan.

The digital design for which the functionality must be verified is developed using Hardware Description Languages (HDLs) such as Verilog, SystemVerilog or VHDL and implements the features described in the Functional Specification. Design complexity can range from a simple design (which incorporates a few internal modules) to a very complex System-On-Chip (SOC).

Design's functional verification is usually performed using simulation, with a verification environment surrounding the DUT (supplying DUT with stimuli and analyzing DUT outputs or internal states). The functional verification environment is implemented using HVL language (SystemVerilog, e Language or PSL) or in a HDL language (Verilog or VHDL). The functional verification environment creates activity and observes outputs correctness according also to the Functional Specification.

The functional verification environment also includes the functional coverage metrics (as dedicated language statements) to measure the verification completeness. The functional coverage metrics are usually collected at the end of the simulation process. Commonly the verification is split in several separate simulations (so the verification process is split in different tests which are executed, sequentially or in parallel). At the end of each simulation, the functional coverage levels (the degree of completeness for each coverage statement) are reported by the simulator and stored in its databases. The functional coverage completion levels are accumulated from all the simulations, providing at the end the global (accumulated) coverage level for each implemented functional coverage statement.

In the automated verification processes, the different implemented functional coverage statements are linked to the created Verification Plan. This way, the verification engineers can observe over time (during the verification process) the verification progress. They observe the trend of the functional coverage completion level, understanding the performance and efficiency of the verification process. In many cases, modifications or corrections of the verification environment (or of the DUT) can downturn the coverage trend (the functional verification process becoming less efficient than before).

All these observations about the functional coverage completion level and trend are commonly used by verification engineers to understand, quantify and qualify the overall design verification process.

In order to understand how much of the DUT internal nodes and paths were exercised during simulations, the simulation tools provide information about code coverage. Different code coverage metrics are available: toggle, statement, branch, condition expression, path and Finite State Machine (FSM) coverage. Verification completeness can be reached with a high percentage of functional coverage combined with code coverage. All the coverage information is stored in a database and presented in a colored readable format for further analysis. Code coverage alone can measure the efficiency of the stimuli generation and correlated with the HDL schematic view could provide a mean to assess verification progress.

The solutions available for different types of coverage analysis are good enough to ensure a DUT verification completeness and with some efforts a manual correlation of the coverage results with a schematic view is possible.

It is an object of the present invention to provide a solution for a clearer analysis of a coverage of a verification of a Design Under Test.

This objective is achieved by the respective subject matter of the independent claims. Further implementations and preferred embodiments are subject matter of the dependent claims.

A first aspect of the present invention relates to a method of operating a hardware verification device. The method comprises the following steps performed by the hardware verification device.

A first step comprises receiving a schema representation of the design under test, comprising schema modules arranged in a predefined schema structure.

A next step is to receive a hardware description representation of the design under test for verification by the verification device, comprising hardware modules arranged in a predefined hierarchical hardware structure. The hardware description representation of the design under test may be provided in a hardware description language (HDL) such as Verilog, SystemVerilog or VHDL.

The next step involves receiving a verification plan that defines the metrics to be covered by verification simulations of the design under test using the hardware description representation. The verification plan defines at least one coverage metric to be used to describe verification coverage. According to the verification plan, a respective coverage level value according to the at least one coverage metric is to be provided for each of the hardware modules in the simulation.

In other words, the verification plan outlines the metrics to be covered by verification simulations to verify the design under test. The simulation for verification uses the hardware description representation of the design under test. The verification plan specifies at least one coverage metric to describe a coverage of the verification achieved in the simulation. The verification plan further configures the simulation to provide respective coverage level values for the individual hardware modules of the hardware description representation.

The next step is to perform verification simulations of the design under test according to the verification plan. The verification simulations may be performed by providing a verification environment. The verification environment may be configured to provide predefined input data to the design under test and to receive the output data generated by the design under test. The verification environment may be configured to compare the output data generated by the design under test with expected output data defined in the verification environment. The verification simulations may also record the respective coverage level values of the respective coverage metric to describe the verification coverage. The verification simulation may generate the respective coverage level values for the respective hardware modules of the design under test.

At the end of the simulation, the respective coverage level values generated for the respective hardware modules according to the respective coverage metric are provided to a database. The respective coverage values generated in the simulation are combined with the respective coverage values from the database to evaluate global coverage values for the respective modules of the design under test. The database may include respective coverage values from previous simulations performed on the design under test. The global coverage is used to define the coverage achieved by the set of simulations for the design under test.

The next step is a generation based on the respective global coverage level values for the respective hardware modules of the hardware description representation a generation of the respective global coverage level use for the respective schema modules of the schema representation of the design under test. The conversion is performed according to a predefined conversion table.

A next step is to provide the respective global coverage level values for the respective schema modules of the scheme are representation of the design under test. In other words, the schema representation of the design under test is extended by the respective global coverage level values for the respective schema modules.

The next step is the provision of a signal comprising the schematic representation of the design under test (DUT).

The advantage of the invention is that the respective global coverage level values evaluated for the hardware description representation of the design under test may be used to evaluate the respective global coverage value for a schematic representation of the design under test. Thus, coverage may be defined for different representations of the design under test.

The invention also comprises further embodiments.

According to a further embodiment of the present invention, the predefined conversion table defines a relationship of a level of abstraction between the hardware description representation of the design under test and the schematic representation of the design under test. In other words, the schematic representation of the design under test and the hardware description representation of the design under test comprise respective modules. It may be the case that the hardware modules used in the hardware description representation correspond to the schematic modules used in the schematic representation. In this case, the global coverage value of the hardware module of the hardware description representation can be used to provide the global coverage value of the schematic module of the schematic representation. It is also possible for the hardware modules of the hardware description representation to be different from the schematic modules of the schematic representation. For example, the schematic module of the schematic representation may be related to two or more of the hardware modules of the hardware description representation. Therefore, the global coverage value of the two or more of the hardware modules of the hardware description representation must be combined according to the conversion table to generate the global coverage value of the schematic module of the schematic representation. The embodiment has the advantage that conversions can be made between representations using different levels of abstraction.

According to a further embodiment of the present invention, the predefined conversion table defines a relationship between the coverage metric of the hardware description representation and a coverage metric of the schema representation. In other words, the global coverage metric of the hardware description representation may be different from the global coverage metric of the schema representation. Therefore, to obtain the global coverage value of the schema representation, the hardware description representation coverage metric must be converted to the schema representation coverage metric.

According to a further embodiment of the present invention, the global coverage metric of the schema representation is a combination of at least two global coverage metrics of the hardware description representation. In other words, the global coverage used in the schema representation of the design under test depends on at least two global coverage used in the hardware description representation of the design under test. For example, the coverage metric of the schema representation may depend on two coverage metrics of the hardware description representation, comprising a code coverage metric and a functional coverage metric. According to a further embodiment of the present invention the hardware description representation is structured according to Verilog or VHDL. In other words, the hardware description representation (HDL) utilized for the design under test is structured in compliance with the Verilog or VHSIC Hardware Description Language. This well-established HDL offers a rich set of features and constructs that enable engineers to create detailed, hierarchical models of complex digital systems.

According to further embodiment of the present invention the schema representation of the design under test is structured according to schema standard used in Verilog. In other words, according to the embodiment, the schema representation for the design under test follows the schema standard inherent in the Verilog hardware description language (HDL). This implies that the structure and organization of the system under test are defined using the same conventions and rules as those found in Verilog. The chosen schematic illustration standard in Verilog offers a consistent and unified method for visually depicting the design, allowing designers to create graphical representations using familiar symbols and conventions. The standard also supports hierarchical decomposition, promoting modularity and reusability by enabling designers to focus on individual components without losing sight of the overall system context. By integrating the schematic illustration standard within Verilog, designers can translate their visual models into HDL code seamlessly, ensuring compatibility across different stages of the design flow. This integration is further supported by various electronic design automation (EDA) tools and simulators that work with this standard in Verilog, streamlining the development process.

According to a further embodiment of the present invention, the signal comprising the extended schema representation of the design under test is configured as a graphic signal defining a graphic to be displayed by a display device. In other words, the signal associated with the extended schema representation of the design under test is structured as a graphical signal. This graphical signal encodes information necessary for generating and rendering a visual representation - specifically, a graphic - intended for display on a graphics-capable device, such as a monitor or touchscreen.

For use cases or use situations which may arise in the methods and which are not explicitly described here, it may be provided that, in accordance with the methods, an error message and/or a prompt for user feedback is output and/or a default setting and/or a predetermined initial state is set.

A 2^{nd} aspect of the present invention is related to a hardware verification device.

The hardware verification device is configured to perform a method according to the first aspect of the present invention.

Therefore, the hardware verification device is configured to receive a schema representation of the design under test comprising schema modules arranged in a predefined schema structure. The hardware verification device is further configured to receive a hardware description representation of a design under test for verification. The hardware verification device is configured to receive a verification plan defining the metrics to be covered by verification simulations of the design under test using the core of the description representation. The verification plan defines at least one coverage metric for describing verification coverage associated with the verification. The verification plan defines to provide respective coverage level values for the respective hardware modules. The hardware verification device is configured to perform verification simulations of the design under test according to the verification plan and to generate respective coverage level values for the respective hardware modules. The hardware verification device is configured to combine the respective coverage level values for the respective hardware modules of the simulations into respective global coverage level values for the respective hardware modules. The hardware verification device is configured to generate, based on the respective global coverage level values for the respective hardware modules, respective global coverage level values for the respective schema fuels according to a predefined conversion table. The hardware verification device is configured to provide the respective global coverage level values for the respective schema modules to the schema representation of the design under test. The hardware verification module is configured to provide a signal comprising the schema representation of the design under test.

A third aspect of the invention is related to a computer program product comprising program code for performing a method according to the first aspect of the present. The computer program product may also be regarded as a computer program.

A fourth aspect of the invention is related to a computer-readable storage medium comprising at least the computer program product according to the third aspect.

The hardware verification device may comprise computing devices to perform steps of the methods.

A computing device may in particular be understood as a data processing device, which comprises processing circuitry. The computing device may therefore in particular process data to perform computing operations. This may also include operations to perform indexed accesses to a data structure, for example a look-up table, LUT.

In particular, the computing device may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing device may also include one or more processors, for example one or more microprocessors, one or more central processing devices, CPU, one or more graphics processing devices, GPU, and/or one or more signal processors, in particular one or more digital signal processors, DSP. The computing device may also include a physical or a virtual cluster of computers or other of said devices.

In various embodiments, the computing device includes one or more hardware and/or software interfaces and/or one or more memory devices.

A memory device may be implemented as a volatile data memory, for example a dynamic random access memory, DRAM, or a static random access memory, SRAM, or as a non-volatile data memory, for example a read-only memory, ROM, a programmable read-only memory, PROM, an erasable read-only memory, EPROM, an electrically erasable read-only memory, EEPROM, a flash memory or flash EEPROM, a ferroelectric random access memory, FRAM, a magnetoresistive random access memory, MRAM, or a phase-change random access memory, PCRAM.

*Independent of the grammatical term usage, individuals with male, female or other gender identities are included within the term.*

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, are also comprised by the invention. Moreover, embodiments and combinations of features which go beyond or deviate from the combinations of features set forth in the recitations of the claims are comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,
FIG 1 shows a schematic illustration of a method to operate a hardware verification device;
FIG 2 shows a schematic illustration of a verification device performing the method shown in FIG 1; and
FIG 3 shows a schematic illustration of a schema representation of a design under test.

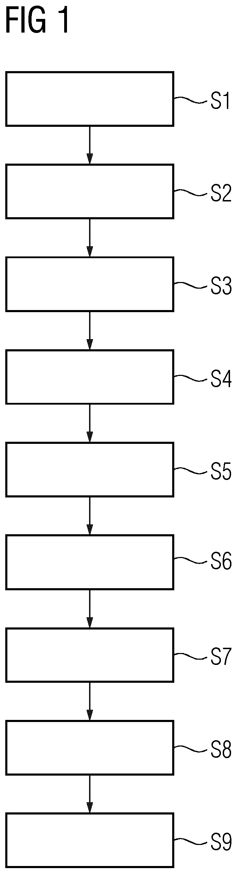

FIG 1 shows a schematic illustration of a method to operate a hardware verification device.

In a first step S1, the hardware verification device 10 may receive a schema representation 14 of the design under test 12. The schema representation 14 may comprise schema modules 16 arranged in the predefined schema structure. The modules of the schema may represent hardware elements of the design under test 12, connections between hardware elements of the design under test 12 and groups of hardware elements of the design under test 12.

In the second step S2, the hardware verification device 10 may receive a hardware description representation 18 of the design under test 12. The hardware description representation 18 of the design under test 12 may be configured for a verification simulation to be performed by the verification device. The hardware description representation 18 may comprise hardware modules 20 arranged in the predefined hierarchical hardware structure. The hardware modules 20 may be related to the schema modules 16. It may also be possible for the hardware modules 20 to relate to a different hierarchical level than the schema representation 14 of the design under test 12. It may therefore be possible for one hardware module 20 to represent two or more of the schema modules 16, or vice versa.

In a third step S3, the hardware verification device 10 may receive a verification plan 22 that defines the metrics to be covered by verification simulations of the design under test 12. The verification plan 22 defines the metrics to be covered by verification simulation to be performed using the hardware description representation 18 of the design under test 12.

In a fourth step S4 of the method, the verification device may perform verification simulations. To perform the verification simulations, the verification device may set up a verification environment 24. After each of the simulations, the hardware verification device 10 may provide coverage level values 32 according to predefined coverage metrics to describe the coverage obtained in the respective verification simulation. The verification plan 22 may be configured to define that a respective coverage level value 32 is provided for each of the hardware modules 20 of the hardware description representation 18 of the design under test 12. The respective coverage level value 32 may define a coverage of the verification of the respective hardware module 20.

In a fifth step S5, the hardware verification device 10 may combine the coverage level values 32 of the simulations to global coverage values 34 of the respective hardware modules 20. The global coverage values 34 may describe the coverage of the verification with respect to the respective hardware modules 20 received by the simulations.

In a sixth step S6, based on the respective global coverage level values 32 for the respective hardware modules 20, the hardware verification device 10 may generate respective global coverage level values 32 for the respective schema modules 16 according to a predefined conversion table 36. The predefined conversion table 36 may describe relationships between the hardware modules 20 and the schema modules 16 as well as coverage metrics used by the hardware description representation 18 of the design under test 12 and used by the schema representation 14 of the design under test 12. The conversion table 36 may further include instructions for combining coverage values of the hardware modules 20 to generate coverage values of the schema modules 16.

In a seventh step S7, the hardware verification device 10 may provide the respective global coverage level values 32 for the respective schema modules 16 to the schema representation 14 of the design under test 12. In other words, the global coverage level values 32 are linked by the hardware verification device 10 to the respective schema modules 16 of the schema representation 14 of the design under test 12.

In an eighth step S8, the hardware verification device 10 may provide a signal 40 comprising the schema representation 14 of the design under test 12 with the respective global coverage level values 32.

In a ninth step S9, the signal 40 may be received by a further device 42 configured to evaluate the verification based on the schematic representation of the design under test 12 comprising the respective global coverage level values 32. The further device 42 may also provide a visual output based on the schema representation 14 of the design under test 12.

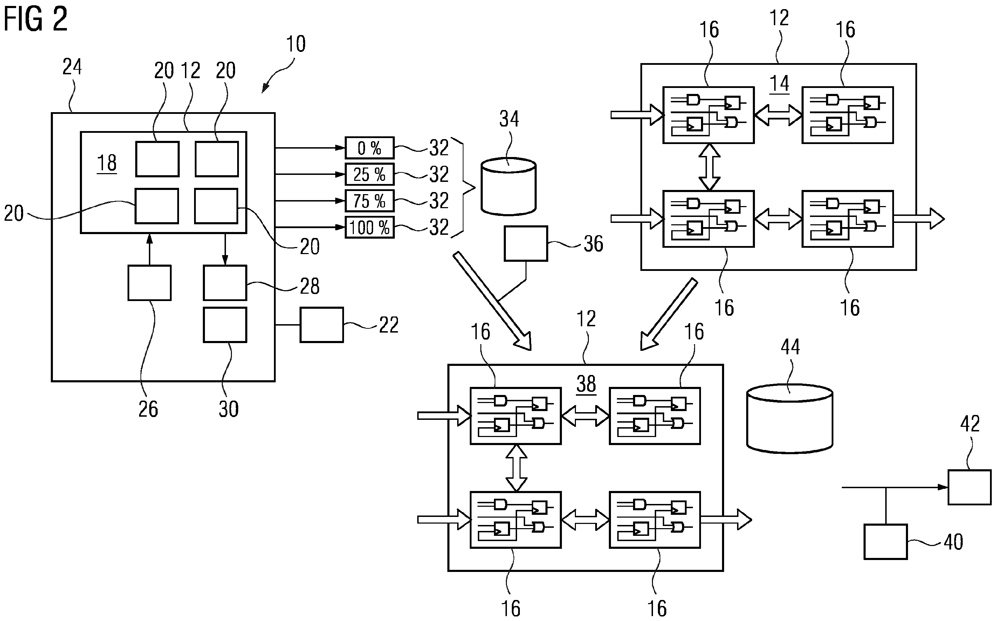

FIG 2 shows a schematic illustration of a verification device performing the method shown in FIG 1.

The hardware verification device 10 can be configured to perform verification of the design under test 12 by providing a verification environment 24. The design under test 12 is provided in a hardware description representation 18. During the verification procedure, simulations are performed in the verification environment 24 where predefined input data 26 are provided to the design under test 12 according to the verification plan 22. The design under test 12 provides corresponding output data 28. The update is compared with the expected output data 30 by the hardware verification tool. To monitor the progress of the verification, the verification plan 22 defines a coverage metric. The coverage metric can be a functional coverage metric or a code coverage metric. At the end of the simulation, the hardware verification device 10 may provide respective coverage level values 32 for each of the hardware modules 20 of the hardware description representation 18 of the design under test 12. The respective coverage level values 32 may indicate how many functions of the respective hardware module 20 were covered during the simulation.

The respective coverage level values 32 can be provided to the coverage database. The coverage database may comprise the respective coverage level values 32 of previous simulations. The hardware verification device 10 may evaluate global coverage level values 32 for the respective hardware modules 20. The global coverage level values 32 may describe the coverage achieved by all simulations.

The global coverage level values 32 can indicate the progress of the verification of the design under test 12, based on the hardware description representation 18 of the design under test 12. However, there may be other representations of the design under test 12. It may be necessary to provide coverage values for the other representations of the design under test 12.

As an example, a schematic representation of the design under test 12 may be provided to the verification device. The schematic may be related to the same design under test 12 represented by the hardware description representation 18 of the design and the test. The schematic representation of the design under test 12 may comprise schematic modules which may be related to the hardware modules 20 of the hardware description representation 18. The schematic modules may be different from the hardware modules 20.

In order to provide global coverage level values 32 for the schematic representation of the design under test 12, a conversion table 36 may be provided to the hardware verification device 10. The conversion table 36 may include, for example, rules for relating the hardware modules 20 to the schematic modules. The conversion table 36 may further comprise rules for changing a coverage metric used for the hardware description representation 18 to a coverage metric used for the schematic representation. The hardware verification device 10 may convert the respective global coverage level values 32 and provide the respective global coverage level values 32 to the schematic representation of the design under test 12 in a schematic coverage database.

In a next step, the hardware verification device 10 may provide a signal 40 comprising the schematic representation of the design under test 12 to another device. The other device may be configured to analyse the schematic representation of the design under test 12 and/or to display the schematic representation of the design under test 12 on screen.

In case of a SoC or a larger design where clear separations of sub-modules is possible and the metrics enclosed in the verification plan 22 are following the same separation, different sections of the verification plan 22 can be attached to the schematic view to provide a visual mean to track the verification progress. This approach is suitable in case of functional verification and formal verification metrics mapped in a verification plan 22.

In case of the code coverage metrics provided by the simulation tool, the collected results can be mapped to the schematic view with better granularity, from top level down to the signals 40 defined in any part of the DUT.

The coverage results collected in a database are attached to the information used to produce the schematic view, resulting in a database where for each signal 40 related information is stored, containing different coverage metric results.

Default coverage color scheme is provided, but the user can extend this scheme defining other coloring rules if necessary.

The novelty of the invention derives from the use of the available solutions for different coverage analysis combined with the available schematic view of HDL implementation, providing a mean to visualize the coverage results from the schematic view perspective. This approach is best suited in case of code coverage combined with the schematic view. The result is comparable to the thermal view of DUT activity.

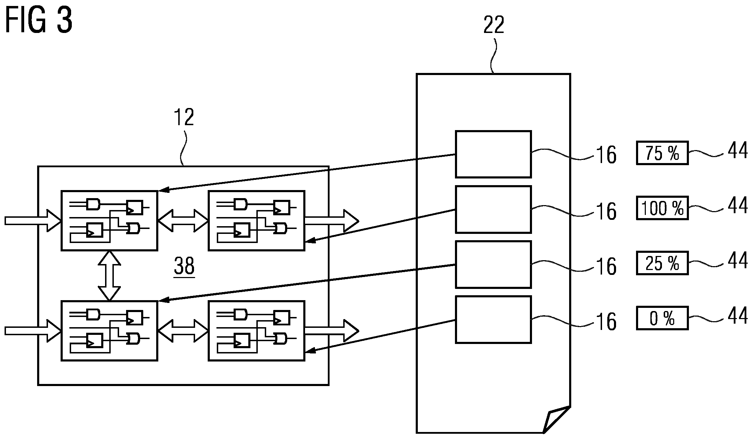

FIG 3 shows a schematic illustration of a schema representation of a design under test.

The schema representation 14 may be generated by a hardware verification device 10. The schema representation 14 may comprise the converted global coverage level values 44 related to the schema modules 16.

### List of Reference

- 10: Hardware verification device
- 12: Design under test
- 14: Schema representation
- 16: Schema module
- 18: Hardware description representation
- 20: Hardware module
- 22: Verification plan
- 24: Verification environment
- 26: Input data
- 28: Output data
- 30: Expected output data
- 32: Coverage level value
- 34: Global coverage value
- 36: Conversion table
- 38: Schema representation with coverage
- 40: Signal
- 42: Further device
- 44: Global converted coverage value

## Claims

1. Method of operating a hardware verification device (10), the method comprising the following steps performed by a hardware verification device (10):
- receiving a schema representation (14) of the design under test (12), comprising schema modules (16) arranged in a predefined schema structure;
- receiving a hardware description representation (18) of the design under test (12) for verification by a verification device, comprising hardware modules (20) arranged in a predefined hierarchical hardware structure;
- receiving a verification plan (22) defining the metrics to be covered by verification simulations of the design under test (12) using the hardware description representation (18), wherein the verification plan (22) defines at least one coverage metric for describing a verification coverage related to the respective coverage level values (32) for the respective hardware modules (20),
- performing verification simulations of the design under test (12) according to the verification plan (22), combining the respective coverage level values (32) for the respective hardware modules (20) of the simulations to respective global coverage level values (32) for the respective hardware modules (20);
- generating based on the respective global coverage level values (32) for the respective hardware modules (20) respective global coverage level values (32) for the respective schema modules (16) according to a predefined conversion table (36);
- providing the respective global coverage level values (32) for the respective schema modules (16) to the schema representation (14) of the design under test (12),
- Providing a signal (40) comprising the schema representation (14) of the design under test (12).

2. The method according to claim 1,
wherein
the predefined conversion table (36) defines a relationship of a level of abstraction between the hardware description representation (18) of the design under test (12) and the schematic representation of the design under test (12).

3. The method according to claim 1 or 2,
wherein
the predefined conversion table (36) defines a relationship between the coverage metric of the hardware description representation (18) and a coverage metric of the schema representation (14).

4. The method according to any one of the preceding claims,
wherein
the global coverage metric of the schema representation (14) is a combination of at least two global coverage metrics of the hardware description representation (18).

5. The method according to any one of the preceding claims,
wherein
the hardware description representation (18) is structured according to Verilog or VHDL.

6. The method according to any one of the preceding claims,
wherein
the schema representation (14) of the design under test (12) is structured according to schema standard used in Verilog.

7. The method according to any one of the preceding claims,
wherein
the signal (40) comprising the extended schema representation (14) of the design under test (12) is configured as a graphic signal (40) defining a graphic to be displayed by a display device.

8. A hardware verification device (10), configured to perform a method according to any one of the preceding claims.

9. A computer program product comprising program code for performing a method according to any one of the preceding claims 1 to 7.

10. A computer-readable storage medium comprising at least the computer program product according to claim 9.
